# EUROPÄISCHE PATENTSCHRIFT

(11) **EP 0 302 330 B1**
(45) Veröffentlichungstag und Bekanntmachung des Hinweises auf die Patenterteilung: **15.09.1993**
(21) Anmeldenummer: 88111892.1
(22) Anmeldetag: 23.07.1988
(51) Int. Cl.: H03M 13/12

(54) **Verfahren zum Auswerten von Zweig- und Pfadmetriken sowie Anordnung**
Method and arrangement for evaluating branch and path metrics
Méthode et appareil pour évaluer les métriques de branche et de chemin

(30) Priorität: 03.08.1987 DE 3725655
(43) Veröffentlichungstag der Anmeldung: 08.02.1989
(73) Patentinhaber: ANT Nachrichtentechnik GmbH, D-71522 Backnang (DE)
(72) Erfinder: Heichler, Johannes, Dipl.-Ing., D-7157 Murrhardt 3 (DE)

(56) Entgegenhaltungen:
- EP-A- 139 511
- EP-A- 229 246
- GB-A- 2 123 654
- Hölzler, Holzwarth, "Pulstechnik", Band 1, seiten 286 und 287
- Journal of the British Institution of Electronic and Radio Engineers vol. 56, no. 5, Mai 1986, London GB Seiten 197-206; S. Aftelak & A. Clark: Adaptive Reduced-state Viterbi Algorithm Decoder.

## Beschreibung

Die Erfindung betrifft ein Verfahren zum Auswerten der Zweigmetriken bei der Decodierung von Faltungscodesignalen.

Bei der Decodierung von fehlerkorrigierenden Faltungscodesignalen, insbesondere bei der Viterbi-Decodierung sind sogenannte ACS (Add-Compare-Select) Netzwerke notwendig zum Auswerten der Zweigmetriken und Ermitteln der Pfadmetriken. Aus Proceedings of the IEEE, Vol. 61, No. 3, March 1973, Seiten 268 bis 277, insbesondere Seite 273 ist es bekannt, solche ACS-Rechenwerke aus parallel arbeitenden Vergleichsstufen und Selektierstufen aufzubauen.

Aus NTC 1982, Vol. 3, Seiten E1.7.1. bis E1.7.4 ist es bekannt, zur Auswertung der Zweigmetriken und Gewinnung der Pfadmetrik ein ACS-Netzwerk für einen Viterbi-Decoder aus je zwei Addierern, einem Komparator, einer Selektierstufe und einem Register aufzubauen.

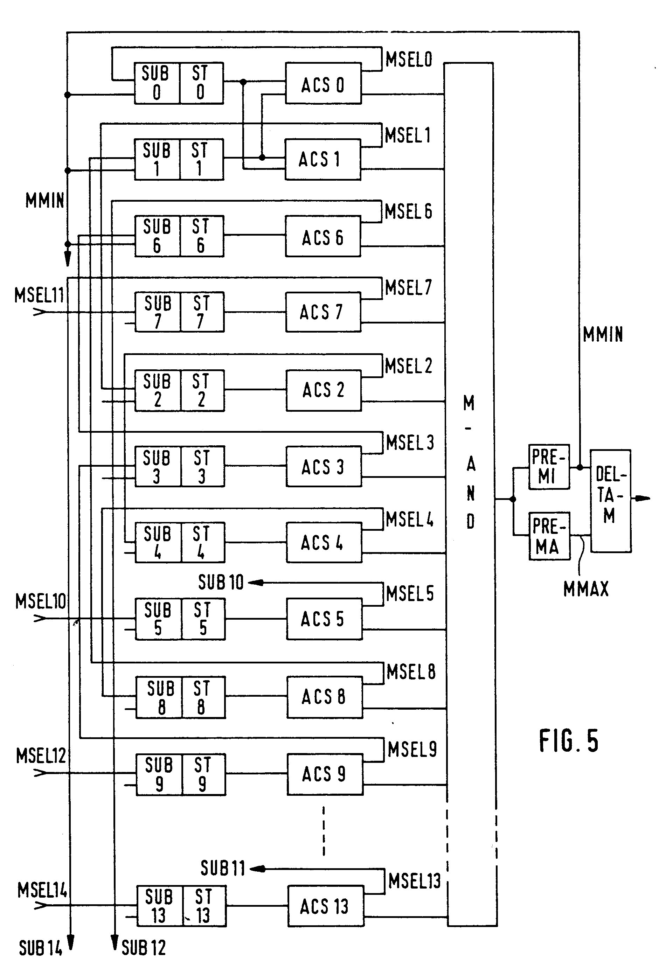

Die DE-A 36 00 905 zeigt zwei weitere Alternativen für ACS-Netzwerke auf- zum einen ein ACS-Netzwerk mit Verarbeitung im logischen Operationsbereich (Fig. 5); d.h. Darstellung einer Binärzahl als Position eines logischen Zustandes in einer Zeile von 2ⁿ Bits, wobei n die Stellenzahl der Binärzahl ist, und zum anderen ein im wesentlichen arithmetisch arbeitendes ACS-Netzwerk (Figur 6). Bei der Anordnung gemäß Figur 5 werden Zweigmetriken in Schieberegister eingelesen. Jeweils zwei Zweigmetriken werden im logischen Operationsbereich addiert, dadurch daß die Schieberegisterinhalte als 2ⁿ breite Bitworte ausgelesen werden und entsprechende Bitpositionen der Schieberegister jeweils in einer Additionsstufe miteinander verknüpft werden. Die Additionsergebnisse werden dann im logischen Operationsbereich gesammelt und einer Multi-AND-Verknüpfungsstufe zugeführt, an deren Ausgang die Minimalmetrik dadurch selektierbar ist, daß die niedrigwertigste bzw. höchstwertigste Bitposition aus jedem Vergleichsergebnis durch einen Prioritätsenkoder detektiert wird. Das Ausgangssignal des Prioritätsenkoders dient dazu das Additionsergebnis zweier Zweigmetriken um den Betrag der minimalen Metrik in einem Schieberegister zurückzuschieben, was im arithmetischen Bereich einer Subtraktion entspricht. Mit diesem Subtraktionsergebnis werden die Schieberegister für die Zweigmetrikinformation aktualisiert. Die Pfadentscheidungsinformation wird ebenfalls im logischen Bereich mit einem Pfadentscheidungsbitdetektor gewonnen, der die Eingangs- und Ausgangsdaten der Multi-AND-Verknüpfungsstufe auswertet.

Bei der arithmetischen Lösung gemäß Figur 6 der DE-A 36 00 905 werden Vergleichsergebnisse von Zweigmetriken, die im arithmetischen Operationsbereich gewonnen werden, mittels eines Multiplexers in ein 2ⁿ breites Bitwort transformiert, um durch die Verknüpfung in der Multi-AND Stufe die Minimalmetrikinformation als Bitposition zu gewinnen.

Aufgabe der Erfindung ist es, das Verfahren eingangs genannter Art so auszugestalten, daß eine schnelle Informationsverarbeitung mit geringem Bauteileaufwand zu realisieren ist. Außerdem soll eine Anordnung zum Auswerten von Zweig- und Pfadmetriken angegeben werden. Diese Aufgabe wird bezüglich des Verfahrens durch die Schritte des Patentanspruchs 1 gelöst und bezüglich der Anordnung durch die Merkmale des Patentanspruchs 2. Der Patentanspruch 3 zeigt eine vorteilhafte Weiterbildung des Verfahrens auf. Die Erfindung geht von der Erkenntnis aus, daß die bisherigen Verfahren zur Zweigmetrikauswertung bzw. die Schaltungsanordnungen hierzu auf mathematisch suboptimaler Verarbeitung beruhten oder nur eine sehr langsame Verarbeitung zuließen, die eine Ermittlung der Pfadmetrik in Echtzeit nicht zuließen, sondern auf Schätzwertermittlung basierten. Die Erfindung gestattet die Lokalisierung der minimalen Metrik in kürzester Zeit bei geringem Schaltungsaufwand; d.h. insbesondere einer Reduzierung logischer Gatterstufen. Durch die schnelle Verarbeitung kann die Differenzmetrik exakt detektiert werden, was insbesondere bei der Synchronisation innerhalb der Viterbi-Decodierung oder bei der Auflösung einer Phasenmehrdeutigkeit wichtig ist.

Anhand der Zeichnungen wird die Erfindung nun näher erläutert. Es zeigen:
Figur 1 ein Prinzipschaltbild der Metrikauswertung,
Figur 2 eine Transformation vom arithmetischen in den logischen Bereich,
Figur 3 den Aufbau einer Multi-UND-Verknüpfungsstufe,
Figur 4 ein Trellis-Diagramm,
Figur 5 eine Gesamtübersicht aller ACS-Netzwerke.

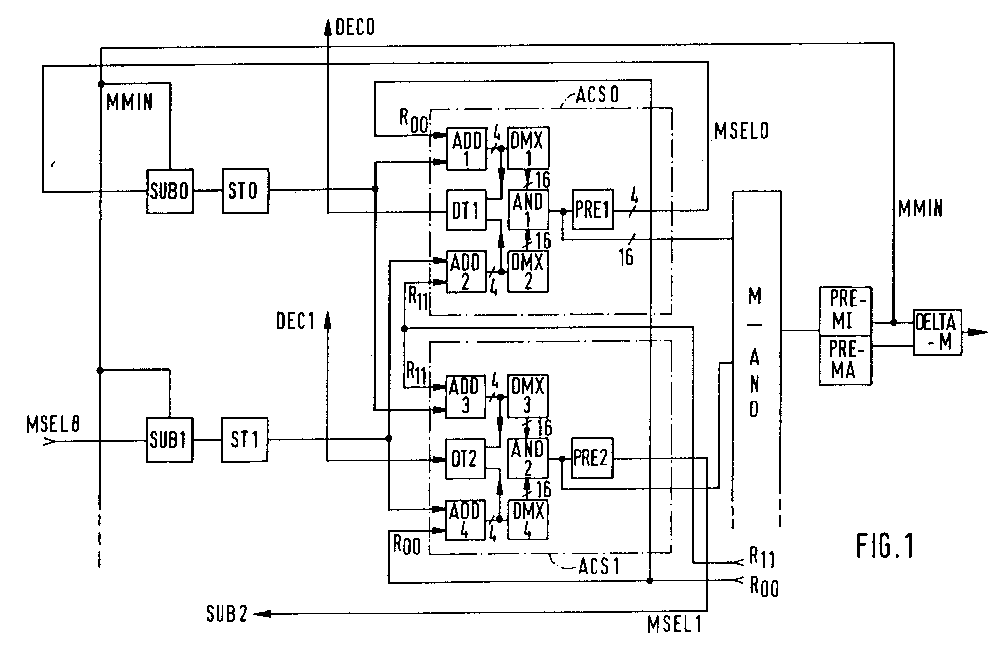

Beim Prinzipschaltbild gemäß Fig. 1 sind zwei von insgesamt 16 ACS-Netzwerken dargestellt. In jedem dieser ACS-Netzwerke werden jeweils entgegengesetzte Zweigmetriken zu jeweils zuvor ermittelten Metrikinformationen addiert. Die Additionsergebnisse werden miteinander verglichen. Die Vergleichsergebnisse aller ACS-Netzwerke werden dann gesammelt und bezüglich extremwertiger Metriken ausgewertet.

Von der durch jede der ACS-Stufen ACS0, ACS1, ... gewonnenen Metrikinformation MSEL wird die aus den gesammelten Vergleichsergebnissen gewonnene extremwertige Metrik - hier die Minimalmetrik MMIN - in einer Subtrahierstufe SUB0, SUB1, ... subtrahiert. Mit dem Subtraktionsergebnis wird jeweils ein jedem ACS-Netzwerk zugeordneter Speicher ST0, ST1, ... aktualisiert, dessen Speicherinhalt für die nächste Addition als "zuvor ermittelte Metrikinformation" zur Verfügung steht.

Wie Fig. 1 zeigt, wird beim ersten ACS-Netzwerk ACS0 mittels eines ersten Addierers ADD1 die jeweils aktuelle Zweigmetrik R₀₀ zum Inhalt des Speichers ST0 addiert. Mittels eines zweiten Addierers ADD2 wird die jeweils aktuelle entgegengesetzte Zweigmetrik R₁₁ zum Inhalt des dem nächsten ACS-Netzwerk ACS1 zugeordneten Speichers ST1 addiert. Die Additionen werden im arithmetischen Bereich vorgenommen, also mit üblichen 4Bit-Binäraddierern. Mittels Transformationsstufen werden die beiden 4Bit-breiten arithmetischen Ausgangsinformationen der Addierer ADD1 und ADD2 in den logischen Bereich transformiert. Diese Transformation kann beispielsweise durch Multiplexer DMX1, DMX2, ... realisiert werden, die die 4Bit-breite Binärzahl umwandeln in einen 2⁴-breiten Binärstrom, in der die Binärzahl als Bitposition z.B. als logischer 0-Zustand unter lauter logischen 1-Zuständen oder als 1-Zustand unter lauter logischen 0-Zuständen gekennzeichnet ist.

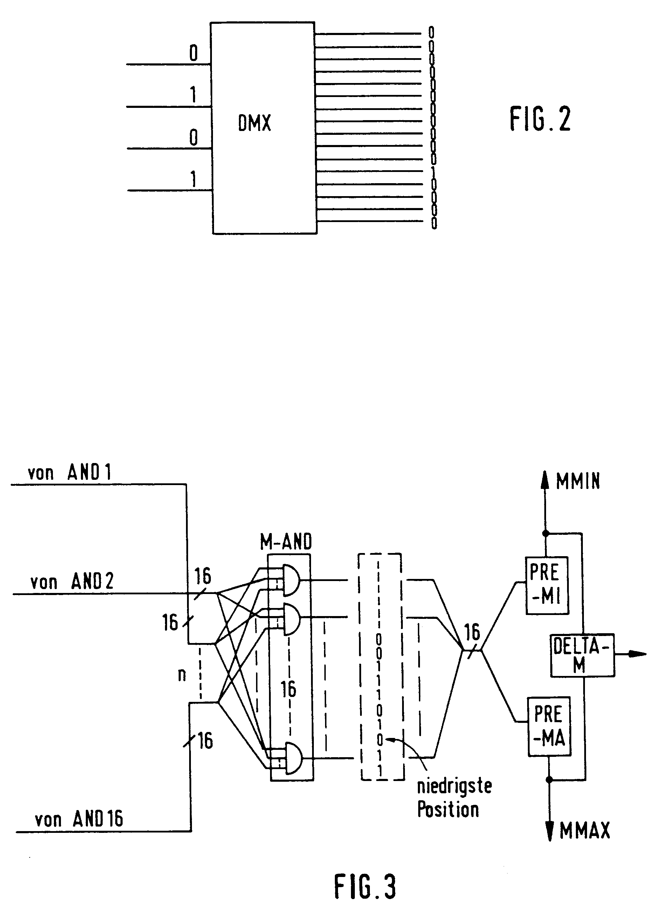

Fig. 2 zeigt schematisch eine solche Transformation. In jeweils einer logischen Vergleichsstufe AND1, AND2, ... werden die beiden logisch transformierten Additionsergebnisse jedes ACS-Netzwerkes miteinander verglichen. Dieser Vergleich erfolgt im logischen Bereich Bit für Bit durch eine UND-Verknüpfung. Am Ausgang jeder Vergleichsstufe AND1, AND2, ... erscheint dann wieder ein 16Bit-breiter Binärstrom mit Kennzeichnung durch die Bitposition. Die Ergebnisse aller Vergleichsstufen AND1, AND2, ... werden im logischen Bereich gesammelt mittels einer Multi-UND-Verknüpfungsstufe M-AND. Der Aufbau dieser Verknüpfungsstufe M-AND ist in Fig. 3 dargestellt. Am Ausgang der Multi-UND-Verknüpfungsstufe sind zwei Prioritätsencoder PRE-MA und PRE-MI angeordnet. Der Prioritätsencoder PRE-MI stellt die niedrigwertigste Bitposition fest und gibt diese in Form einer Binärzahl, also arithmetisch, als Minimalmetrik - Pfadmetrik - MMIN aus. Der Prioritätsencoder PRE-MA stellt die höchstwertigste Bitposition fest und stellt die Maximalmetrik MMAX zur Verfügung. Aus der Minimal- und der Maximalmetrik wird in der Stufe Delta-M die Differenzmetrik durch Subtraktion gebildet. Die ermittelte Differenzmetrik wird beispielsweise zur Synchronisation oder zur Phasenmehrdeutigkeitsauflösung bei der Viterbi-Decodierung benötigt.

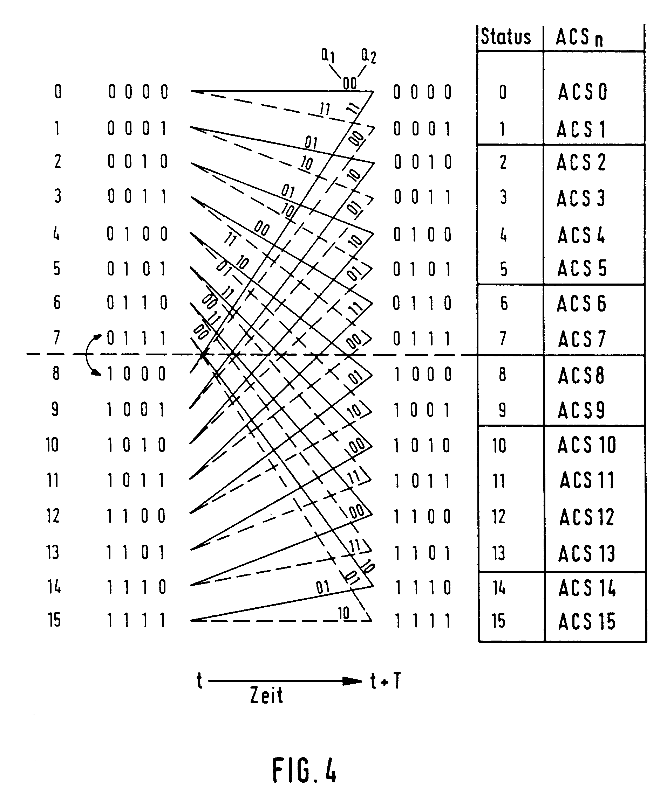

Der Ausgang jeder logischen Vergleichsstufe AND1, AND2, ... eines ACS-Netzwerkes ist mit einem Prioritätsencoder PRE1, PRE2, ... beschaltet, der die extremwertige beim Ausführungsbeispiel die niedrigwertigste - Bitposition aus jedem Vergleichsergebnis selektiert und diese in Form einer Binärzahl im arithmetischen Operationsbereich ausgibt. Diese Binärzahl wird als Metrikinformation MSEL an einen der den ACS-Stufen zugeordneten Subtrahierern SUB0, SUB1, ... mit 4Bit-breiter Verarbeitung abgegeben zur Subtraktion der Minimalmetrik MMIN und Aktualisierung des jeweiligen Speichers ST0, ST01, .... Die Speicher ST0, ST01, ... müssen nur 4Bit-breite Worte aufnehmen, da die vorgeschalteten Subtrahierer und die nachgeschalteten Addierer im arithmetischen Operationsbereich arbeiten. Welche Metrikinformation eines ACS-Netzwerkes zu welchem der Subtrahierer weitergeleitet wird, hängt von dem aus der Literatur hinreichend bekannten Trellisdiagramm für die ACS-Netzwerke ab. Das Trellisdiagramm ist für eine mögliche Viterbi-Decodierung in Fig. 4 dargestellt. Es gibt an, aufgrund welcher Übergänge neue Quellbits Q₁ und Q₂ entstehen können. Entsprechend diesem Trellisdiagramm wird die durch das Netzwerk ACS0 gewonnene Metrikinformation MSEL0 zum Subtrahierer SUB0 geführt, die durch das Netzwerk ACS1 gewonnene Metrikinformation MSEL1 jedoch zum Subtrahierer SUB2, der dem Netzwerk ACS2 zugeordnet ist. Der dem Netzwerk ACS1 zugeordnete Subtrahierer SUB1 erhält die Metrikinformation MSEL8 des Netzwerks ACS8. Fig. 5 zeigt die Verbindungswege zwischen allen 16 ACS-Netzwerken.

Jedes ACS-Netzwerk enthält noch eine Stufe, die bisher nicht angesprochen wurde. Es handelt sich um Komparatoren DT1, DT2, ... zur Gewinnung jeweils einer Pfadentscheidungsinformation DEC0, DEC1, ..., die für die weitere Viterbi-Decodierung benötigt wird.

Die Komparatoren DT1, DT2, ... vergleichen jeweils die Additionsergebnisse der beiden Addierer ADD1, ADD2, ... vor der Transformation in den logischen Bereich in jedem ACS-Netzwerk im arithmetischen Opterationsbereich, also bezüglich 4Bit-breiter Worte. Als Pfadentscheidungsinformation wird jeweils ausgegeben, ob die Differenz beider Additionsergebnisse ≧ 8 oder < 8 ist.

## Patentansprüche

1. Verfahren zum Auswerten der Zweigmetriken bei der Decodierung von Faltungscodesignalen, mit folgenden Schritten:
a) Addieren jeweils einer aktuellen Zweigmetrik zu einer in einem Speicher abgelegten zuvor ermittelten Metrikinformation,
b) Transformieren des Additionsergebnisses vom arithmetischen in den logischen Bereich, dadurch daß die bei der Addition entstehende Binärinformation als Bitposition innerhalb eines 2ⁿ-zeiligen Bitwortes, mit n=Stellenzahl der Binärzahl, dargestellt wird,
c) Vergleichen der logisch transformierten Additionsergebnisse im logischen Bereich jeweils bezüglich zweier von entgegengesetzten Zweigmetriken stammenden Additionsergebnissen,
d) Selektieren der Minimalmetrik als niedrigwertigste bzw. höchstwertigste Bitposition aus jedem Vergleichsergebnis,
e) Sammeln aller Vergleichsergebnisse im logischen Bereich,
f) Selektieren der Minimalmetrik aus allen Vergleichsergebnissen als niedrigwertigste bzw. höchstwertigste Bitposition aus den gesammelten Vergleichsergebnissen,
g) Subtrahieren der aus den gesammelten Vergleichsergebnissen gewonnenen Minimalmetrik von der aus jedem Vergleich gewonnenen Minimalmetrik im arithmetischen Bereich,
h) Aktualisieren der in jedem Speicher abgelegten Metrikinformation durch das Subtraktionsergebnis,
i) Vergleichen jeweils zweier entgegengesetzter Additionsergebnisse im arithmetischen Bereich zur Gewinnung einer Pfadentscheidungsinformation.

2. Anordnung zum Auswerten der Zweigmetriken bei der Decodierung von Faltungscodesignalen, bestehend aus:
- Addierern (ADD1, ADD2, ...) mit zugeordneten Speichern (ST0, ST1, ...) zur Addition jeweils einer aktuellen Zweigmetrik zu einer zuvor ermittelten Metrikinformation,
- Multiplexern (DMX1, DMX2, ...) zur Transformation der Additionsergebnisse vom arithmetischen in den logischen Operationsbereich, dadurch daß die bei der Addition entstehende Binärinformation als Bitposition innerhalb eines 2ⁿ-zeiligen Bitwortes, mit n=Stellenzahl der Binärzahl, dargestellt wird,
- UND-Verknüpfungsstufen (AND1, AND2, ...) zum Vergleich jeweils zweier transformierter Additionsergebnisse,
- Prioritätsencodern (PRE1, PRE2, ...) zur Selektion der niedrigwertigsten bzw. höchstwertigsten Bitposition aus jedem Vergleichsergebnis,
- einer Multi-UND-Verknüpfungsstufe (M-AND) zum Sammeln aller Vergleichsergebnisse im logischen Bereich,
- einem Prioritätsencoder (PRE-MA, PRE-MI) zur Selektion der niedrigwertigsten bzw. höchstwertigsten Bitposition aus allen gesammelten Vergleichsergebnissen,
- Subtrahierern (SUB1, SUB2, ...) zur Subtraktion der aus allen Vergleichsergebnissen gewonnenen Minimalmetrik von der aus jedem Vergleich gewonnenen Minimalmetrik,
- Verbindungen von den Subtrahierern (SUB0, SUB1, ...) zu den Speichern (ST0, ST1, ...) zur Aktualisierung der in jedem Speicher abgelegten Metrikinformation durch das jeweilige Subtraktionsergebnis,
- einem Schwellwertdetektor (DT1, DT2, ...), zur Gewinnung einer Pfadentscheidungsinformation aus jeweils zwei nichttransformierten Additionsergebnissen.

3. Verfahren nach Anspruch 1, gekennzeichnet durch
- Selektieren der niedrigwertigsten und der höchstwertigsten Bitposition aus den gesammelten Vergleichsergebnissen,
- Subtrahieren dieser beiden extremwertigen Bitpositionen,
- Ausgeben des Subtraktionsergebnisses als Pfadmetrikdifferenz.

## Claims

1. A method of evaluating the branch metrics during the decoding of convolution code signals, the method comprising the following steps:
a) adding one current branch metric at a time to one metric information previously determined and stored in a memory;
b) transforming the addition result from the arithmetic into the logic domain in that the binary information produced during the addition is represented as a bit position within a bit word having 2ⁿ rows where n is the place number of the binary number;
c) comparing the logically transformed addition results in the logic domain, in each case with respect to two addition results derived from opposed branch metrics;
d) selecting the minimum metric as the least significant or most significant bit position from each comparison result;
e) collecting all the comparison results in the logic domain;
f) selecting the minimum metric from all comparison results as the least significant bit or the most significant bit position from among the collected comparison results;
g) subtracting the minimum metric obtained from the collected comparison results from the minimum metric obtained from each comparison in the arithmetic domain;
h) updating the metric information stored in each memory by means of the subtraction result;
i) comparing two opposed results of addition at a time in the arithmetic domain for obtaining a path decision information.

2. An arrangement for evaluating the branch metrics during the decoding of convolution code signals, the arrangement comprising:
- adders (ADD1, ADD2, ...) with associated memories (ST0, ST1, ...) for the addition of one current branch metric at a time to a previously determined metric information;
- multiplexers (DMX1, DMX2, ...) for the transformation of the addition results from the arithmetic into the logic domain of operation in that the binary information produced during the addition is represented as a bit position within a bit word having 2ⁿ rows where n is the place number of the binary number;
- AND linkage stages (AND1, AND2, ...) for the comparison of two transformed addition results at a time;
- priority encoders (PRE1, PRE2, ...) for the selection of the least significant or most significant bit position from each comparison result;
- a multi-AND-linking stage (M-AND) for collecting all the comparison results in the logic domain;
- a priority encoder (PRE-MA, PRE-MI) for selecting the least significant or most significant bit position from all collected comparison results;
- subtractors (SUB1, SUB2, ...) for the subtraction of the minimum metric obtained from all comparison results from the minimum metric obtained from each comparison;
- connections from the subtractors (SUB0, SUB1, ...) to the memories (ST0, ST1, ...) for updating the metric information stored in each memory by means of the respective subtraction result;
- a threshold value detector (DT1, DT2, ...), for obtaining a path decision information from every two non-transformed addition results.

3. A method according to claim 1, characterized by
- selecting the least significant and of the most significant bit position from the collected comparison results;
- subtracting these two extreme-value bit positions;
- putting out the subtraction result as the path metric difference.

## Revendications

1. Procédé pour évaluer les métriques de branche dans le décodage de signaux de code de convolution, comprenant les étapes suivantes:
a) addition de chaque fois une métrique de branche actuelle à une information de métrique déterminée précédemment et stockée dans une mémoire,
b) transformation du résultat d'addition du domaine arithmétique dans le domaine logique, du fait que l'information binaire formée lors de l'addition est représentée comme une position binaire dans un mot binaire à 2ⁿ lignes, où n = le nombre de chiffres du nombre binaire,
c) comparaison dans le domaine logique des résultats d'addition, transformés dans le domaine logique, la comparaison portant chaque fois sur deux résultats d'addition provenant de métriques de branche contraires,
d) sélection de la métrique minimale en tant que position binaire de poids le plus faible ou position binaire de poids le plus fort dans chaque résultat de comparaison,
e) rassemblement de tous les résultats de comparaison dans le domaine logique,
f) sélection de la métrique minimale à partir de tous les résultats de comparaison, en tant que position binaire de poids le plus faible ou position binaire de poids le plus fort parmi les résultats de comparaison rassemblés,
g) soustraction, dans le domaine arithmétique, de la métrique minimale obtenu à partir des résultats de comparaison rassemblés de la métrique minimale obtenue de chaque comparaison,
h) actualisation de l'information de métrique stockée dans chaque mémoire par le résultat de la soustraction et
i) comparaison, dans le domaine arithmétique, de chaque fois deux résultats d'addition contraires en vue de l'obtention d'une information de décision de chemin.

2. Dispositif pour évaluer les métriques de branche dans le décodage de signaux de code de convolution, comprenant:
- des additionneurs (ADD1, ADD2, ...) avec des mémoires coordonnées (ST0, ST1, ...) pour additionner chaque fois une métrique de branche actuelle à une information de métrique déterminée précédemment,
- des multiplexeurs (DMX1, DMX2, ...) pour transformer les résultats d'addition du domaine arithmétique dans le domaine d'opération logique, du fait que l'information binaire formée lors de l'addition est représentée comme une position binaire dans un mot binaire à 2ⁿ lignes, où n = le nombre de chiffres du nombre binaire,
- des étages de conjonction ET (ET1, ET2, ...) pour comparer chaque fois deux résultats d'addition transformés,
- des codeurs de priorité (PRE1, PRE2, ...) pour sélectionner la position binaire de poids le plus faible ou la position binaire de poids le plus fort dans chaque résultat de comparaison,
- un étage de conjonction ET multiple (M-ET) pour rassembler tous les résultats de comparaison dans le domaine logique,
- un codeur de priorité (PRE-MA, PRE-MI) pour sélectionner la position binaire de poids le plus faible ou la position binaire de poids le plus fort parmi tous les résultats de comparaison rassemblés,
- des soustracteurs (SUB1, SUB2, ...) pour déduire la métrique minimale obtenue à partir de tous les résultats de comparaison de la métrique minimale obtenue de chaque comparaison,
- des connexions allant des soustracteurs (SUB0, SUB1, ...) aux mémoires (ST0, ST1, ...) pour actualiser l'information de métrique stockée dans chaque mémoire par le résultat de la soustraction correspondante et
- un détecteur de seuil (DT1, DT2, ...) pour obtenir une information de décision de chemin à partir de chaque fois deux résultats d'addition non transformés.

3. Procédé selon la revendication 1, caractérisé par
- la sélection de la position binaire de poids le plus faible et de la position binaire de poids le plus fort parmi les résultats de comparaison rassemblés,
- la soustraction de ces deux positions binaires de valeurs extrêmes et
- la délivrance du résultat de la soustraction sous forme de différence de métrique de chemin.
